# EUROPEAN PATENT SPECIFICATION

(11) **EP 3 144 974 B1**
(45) Date of publication and mention of the grant of the patent: **26.01.2022**
(21) Application number: 15185954.3
(22) Date of filing: 18.09.2015
(51) Int. Cl.: H01L 29/78, H01L 29/08, H01L 21/336

(54) **SEMICONDUCTOR DEVICE**
HALBLEITERBAUELEMENT
DISPOSITIF DE SEMI-CONDUCTEUR

(43) Date of publication of application: 22.03.2017
(73) Proprietor: Ampleon Netherlands B.V., 6534 AV Nijmegen (NL)
(72) Inventor: De Boet, Johannes Adrianus Maria, Redhill, Surrey RH1 1SH (GB)
(74) Representative: Jacobs, Bart

(56) References cited:
- JP-A- 2002 026 315
- US-A1- 2005 184 338
- US-A1- 2006 027 863
- US-A1- 2015 214 222
- SZELAG B ET AL: "NLDMOS RF optimization guidelines for wireless power amplifier applications", BIPOLAR/BICMOS CIRCUITS AND TECHNOLOGY MEETING, 2005. PROCEEDINGS OF THE, IEEE, PISCATAWAY, NJ, USA, 9 October 2005 (2005-10-09), pages 280-283, XP010861884, DOI: 10.1109/BIPOL.2005.1555251 ISBN: 978-0-7803-9309-7
- ZIERAK MICHAEL ET AL: "Fully-isolated silicon RF LDMOS for high-efficiency mobile power conversion and RF amplification", 2013 25TH INTERNATIONAL SYMPOSIUM ON POWER SEMICONDUCTOR DEVICES & IC'S (ISPSD), IEEE, 10 May 2015 (2015-05-10), pages 337-340, XP032785167, ISSN: 1943-653X, DOI: 10.1109/ISPSD.2015.7123458 ISBN: 978-1-4673-5134-8 [retrieved on 2015-06-12]

## Description

The present specification relates to a semiconductor device and to a method of making a semiconductor device.

RF power amplifiers are key components in base stations for personal communication systems (e.g. GSM, EDGE, W-CDMA). RF Laterally Diffused Metal Oxide Semiconductor (RF-LDMOS) transistors are a common choice of technology for power amplifiers of this kind.

In a power amplifier, the DC biasing point is a critical parameter governing performance. The optimum DC biasing point of an RF-LDMOS transistor depends on factors such as temperature and manufacturing process variations. A biasing circuit including a LDMOS transistor may be used to apply the DC bias. The biasing circuit may be integrated in the same semiconductor die as the RF-LDMOS transistor, so that the biasing circuit may compensate for temperature effects. A small reference LDMOS transistor, also provided in the same die, may be used to compensate for the manufacturing process variations.

The patent application publication US2005184338 A1 discloses a circuit that comprises an LDMOS transistor and a biasing circuit, the LDMOS transistor comprising a gate, N-type drain and source regions, wherein the source region is located within a P-type body region, said body region extending laterally within the DC LDMOS transistor to a greater extent than the source region so as to surround the source region, a channel region comprised of a part of said body region, a common contact connected to both the source region and the body region, wherein the semiconductor substrate is P-type doped and wherein the drain region extends beneath the gate, the source region and the body region, the drain region surrounding the body region so that the source region and the body region are electrically cut off from the underlying substrate.

The present invention is defined in appended claim 1.

The drain region having the first conductivity type extending beneath the region having the second conductivity type allows the source region of the device to be isolated from the underlying region of the substrate whereby, during use, different voltages may be applied to the source and the substrate. This allows the device to be operated with a source voltage that is higher than the voltage applied to the substrate (a so called "source-high" device).

A method for making the device is not claimed. It is useful for understanding the present invention that such a method may include implanting ions through the major surface of the substrate for forming the drain region and then heating the substrate to diffuse the implanted ions to form the drain region, wherein the drain region extends beneath the gate, the source region and the region having the second conductivity type. When formed in this way, a part of the drain region located beneath the gate may extend to a depth beneath the major surface that is shallower than a depth to which a part of the drain region not located beneath the gate extends. The relative shallowness of the part of the drain region located beneath the gate may be formed by shadowing of this part of the device by the gate during ion implantation. It has been determined that the relative shallowness of the part of the drain region located beneath the gate may improve the field distribution within the device, allowing for a higher maximum drain to source voltage BV_{dss} owing to the reduced surface field (RESURF) action in the device.

The common contact is connected to both the source region and the region having the second conductivity type. In this way, the source and the channel region of the device are connected together. The contact may include a silicide region located at the major surface, wherein the silicide region extends over a junction between the source region and the region having the second conductivity type.

The source region, the drain region, and the region having the second conductivity type may comprise doped regions located in an epitaxial layer of semiconductor material.

The first conductivity type may be n-type and the second conductivity type may be p-type. Nevertheless, it is envisaged that the first conductivity type may be p-type and the second conductivity type may be n-type.

The power amplifier comprises an LDMOS (Laterally Diffused Metal Oxide Semiconductor) transistor. It comprises an RF-LDMOS transistor for use in Radio Frequency applications.

For the purposes of this disclosure "Radio Frequency" (RF) refers to frequencies in the range 1 GHz ≤ f ≤ 120 GHz.

The power amplifier also comprises a DC LDMOS transistor. The DC LDMOS transistor is included in a DC biasing circuit for a circuit including an RF-LDMOS transistor. The DC biasing circuit is used to bias the RF-LDMOS transistor during operation.

According to the invention, there is provided a power amplifier comprising an RF-LDMOS and a circuit of the kind described above.

According to a further aspect of this disclosure, there is provided a base station comprising a power amplifier of the kind described above.

Embodiments of the present disclosure will be described hereinafter, by way of example only, with reference to the accompanying drawings in which like reference signs relate to like elements and in which:
Figure 1 shows a semiconductor device comprising an RF-LDMOS transistor;
Figure 2 shows a semiconductor device according to an embodiment of the present disclosure;
Figure 3 is a graph showing the source to substrate breakdown of a semiconductor device according to an embodiment of the present disclosure; and
Figure 4 is a graph showing the drain to source breakdown of a semiconductor device according to an embodiment of the present disclosure.

Embodiments of the present disclosure are described in the following with reference to the accompanying drawings.

In the RF power amplifier including an RF-LDMOS transistor, a bias circuit is used to bias the RF-LDMOS transistor to a DC biasing point. The bias circuit includes an LDMOS transistor. The source of the LDMOS transistor may be operated at a (DC biased) voltage above the substrate (the substrate may, for instance, be connected to ground). Such a device may be referred to as a "source-high LDMOS". The biasing circuit including the source-high LDMOS is incorporated into the same substrate as the RF-LDMOS transistor for which the bias point is to be provided.

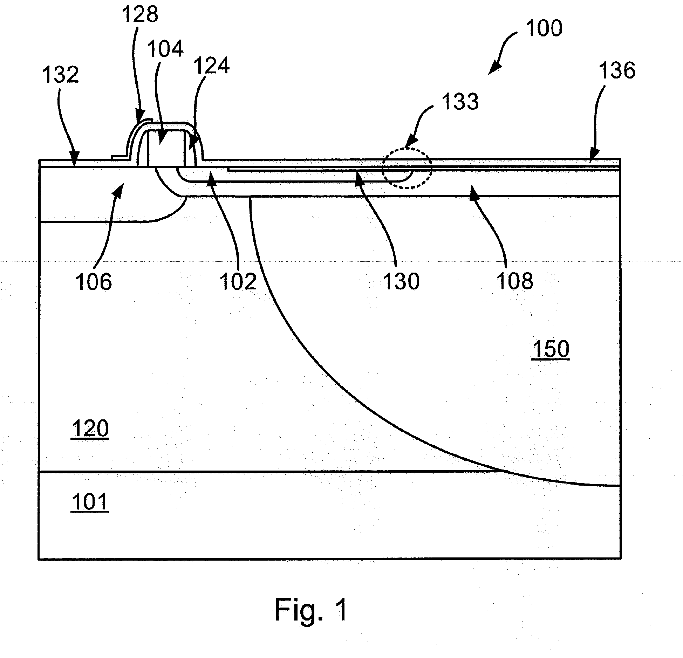

However, within a given RF-LDMOS diffusion technology, a source-high LDMOS transistor is not typically available. Apart from ESD protection devices, the only active component normally available within a given RF-LDMOS diffusion technology is the RF-LDMOS transistor. Source-high operation of such devices is not possible because RF-LDMOS devices are typically manufactured such that the source is connected to the substrate (this is explained in more detail below in relation to Figure 1). Note that in the RF domain, connection of the source to the drain may allow the source to be connected to the flange of the transistor package, which may minimise losses (inductance) in the source connection.

Accordingly, the RF-LDMOS transistors available within a given RF-LDMOS diffusion technology are not typically suitable for use in a DC biasing circuit.

Figure 1 shows a semiconductor device 100 comprising an RF-LDMOS transistor. The device 10 includes a semiconductor substrate 101, which includes an epitaxial layer 120 in which the various features of the RF-LDMOS transistor are provided. The substrate 101 and its epitaxial layer 120 may, for instance, comprise silicon. The substrate 101, including its epitaxial layer 120, is p-type doped. The epitaxial layer 120 may be more lightly doped than the underlying region of the substrate 101. The substrate 101 has a major surface 132.

The RF-LDMOS transistor includes a gate 104 located on the major surface 132. The gate may include a gate electrode separated from a channel region beneath the major surface 132 by a gate oxide. The gate 104 may include spacers 124.

The RF-LDMOS transistor also includes a drain region 106. The drain region 106 is located at the major surface 132 on a first side of the gate 104. The drain region 106 may form a laterally extending drain.

The RF-LDMOS transistor also includes a source region 102. The source region 102 is located at the major surface 132 on a second side of the gate 104.

A protective layer 136 of thermally grown oxide (e.g. TEOS) is provided over the major surface 132. The layer 128 is a shield that may be used to improve the reduced surface field (RESURF) behavior of the device and for reducing hot carrier injections.

In this example, the source region 102 and drain region 106 are n-type. The channel region located beneath the gate 104 comprises p-type semiconductor material. The source region 102 is located within a p-type region 108. A part of the p-type region 108 located beneath the gate 104 forms the channel region of the RF-LDMOS transistor.

As noted previously, in a RF-LDMOS transistor the source is typically connected to the substrate. In the example of Figure 1, this connection is implemented by forming a silicide layer 130 at the major surface 132 of the substrate 101. The silicide layer 130 extends over both the source region 102 and the p-type region 108. This allows a common connection to be made to both the source region 102 and the p-type region 108, whereby the source region 102 may be connected to the substrate 101. To reduce the resistance between the source region 102 and the backside of the substrate 101 may be reduced by providing a strongly doped p-type implant 150 within the epitaxial layer 120 (which, as noted above, may be lightly doped and therefore have a relatively high electrical resistivity).

Because the source region 102 of the device 100 shown in Figure 1 is shorted to the substrate 101 as noted above, the device 100 cannot be operated as a source high LDMOS and is therefore not suitable for use in a bias circuit for biasing the RF-LDMOS transistor of an RF product.

A possible approach to implementing a source-high RF-LDMOS transistor, based on the device 100 shown in Figure 1 might be to remove the short between the source region 102 and the p-type region 108 formed by the silicide layer 130. For instance, this might be achieved by introducing a gap in the silicide layer 130 at the junction between the source region 102 and the p-type region 108 (the gap may be located in the region indicated using reference numeral 133 in Figure 1). A separate connection may then be made to the silicide located on the source region 102, so that different potentials may be applied to the source region 102 and the substrate 101.

However, in an RF-LDMOS device, the diffusions and doping levels of the features of the transistor are generally optimised for RF performance. The steep doping profiles for the source region 102 and the p-type region 108 may give rise to a number of issues. For instance, the breakdown voltage between the source region 102 and the p-type region 108 may be rather low (typically 2-5Volt depending on the processing details), in turn leading to a relatively low maximum breakdown voltage between the source region 102 and the backside of the substrate 101. Also, the device may suffer from leakage due to the silicide layer close the steep junction between the source region 102 and the p-type region 108.

Embodiments of this disclosure provide a power amplifier comprising an LDMOS transistor which may be operated as a source high device. The device includes a drain region and a source region having a first conductivity type. A channel region of the device has a second conductivity type (i.e. a different conductivity type) to the source region and the drain region. The first conductivity type is n-type and the second conductivity type is p-type (so that the source and drain regions are n-type and the channel region is p-type). However, it is envisaged that the first conductivity type may be p-type and the second conductivity type may be n-type.

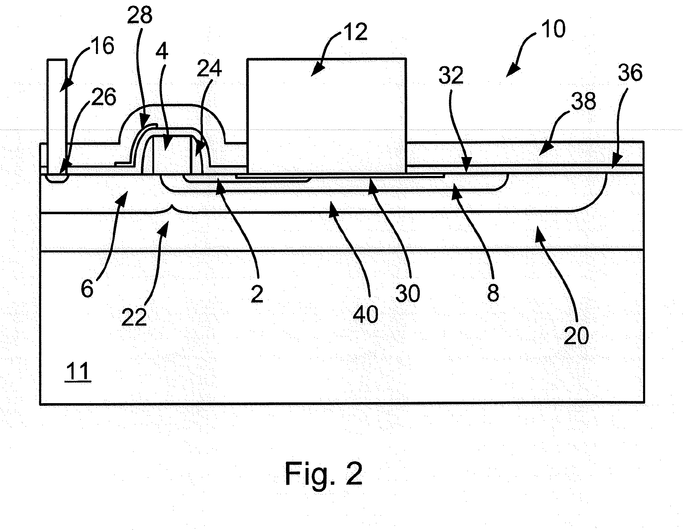

Figure 2 shows a semiconductor device 10 according to an embodiment of the present disclosure. The device 10 in this embodiment comprises an LDMOS transistor. The device 10 includes a semiconductor substrate 11. The substrate 11 may be a silicon substrate. The substrate 11 is doped to have the same conductivity type as a channel region of the device 11 (which in the present example is p-type). The substrate may include an epitaxial layer 20 comprising, for example, silicon. Features of the LDMOS transistor (e.g. the drain region, source region etc.) may be formed in the epitaxial layer 20. The epitaxial layer may have the same conductivity type as the substrate 11, which in this example is p-type. The epitaxial layer 20 may be more lightly doped than the underlying part of the substrate 11. The substrate 11 has a major surface 32.

The device 10 includes a gate 4 located on the major surface 32 of the substrate. The gate 4 may include a gate electrode separated from a channel region beneath the major surface 32 of the substrate by a gate insulation layer, such as an oxide layer. The gate 4 may include spacers 24.

The device 10 also includes a drain region 6. The drain region 6 is located at the major surface 32 of the substrate 11 on a first side of the gate 4. The drain region 6 extends laterally away from the gate 4 along the major surface 32 of the substrate 11.

The LDMOS transistor also includes a source region 2. The source region 2 is located at the major surface 32 on a second side of the gate 4. Like the drain region 4, the source region may extend laterally away from the gate 4 along the major surface 32 of the substrate 11.

As noted above, in this embodiment, the source region 2 and drain region 6 are n-type. The source region 2 is located within a region 8 having the second conductivity type, which in this embodiment is p-type. As with the source region 2 and the drain region 6, the p-type region 8 may extend along the major surface 32 of the substrate 11. As shown in Figure 2, the source region 2 may be located in between the major surface 32 and the p-type region. The p-type region 8 extends laterally within the device 10 to a greater extent than the source region 2, so as to surround the source region 2 beneath the major surface 32. A part of the p-type region 8 extends beneath the gate 4 to form the channel region of the LDMOS transistor.

One or more protective layers 36, 38 of thermally grown oxide (e.g. TEOS) is provided over the major surface 32. The layer 28 is a shield that may be used to improve the reduced surface field (RESURF) behavior of the device and for reducing hot carrier injections.

In this embodiment, a silicide layer 30 is formed at the major surface 32 of the substrate 11 for forming a contact to the source region 2. The silicide layer 30 may extend along a top of the source region 2 at the major surface 32. The silicide layer 30 may also extend along a top of the p-type region 8 so that a common connection may be made to the source region 2 and the p-type region 8. In this way, the source region 2 and the channel region of the device 10 may be operated at the same voltage. Figure 2 also shows the provision of an electrically conductive connection 12 extending upwardly from the silicide layer 30. The connection 12 may connect to further metallisation features provided in the device 10 for routing signals to and from the device 10. Similarly, an electrically conductive connection 16 may be provided to the drain region 6. A highly doped region 26 may be located a top the top of the drain region 6 to receive the connection 16.

Figure 2 also shows that the drain 6 extends beneath the p-type region 8. The region of the drain 6 that extends beneath the p-type region 8 is labelled using reference numeral 40 in Figure 2. The region 40 isolates the source region 2 and the p-type region an underlying region of the substrate 11. Since the source region 2 and the p-type region 8 are isolated from the underlying region of the substrate 11, the source region 2 may be operated at a different voltage to that applied to the backside of the substrate. Accordingly the device 10 may be operated as a source-high LDMOS transistor. Such a device is therefore suitable for use in the DC bias circuit in the RF power amplifier that also includes an RF-LDMOS transistor.

As shown in Figure 2, the region 40 surrounds the p-type region 8 beneath the major surface 32 so that the source region 2 and the p-type region 8 are electrically cut off from the underlying substrate.

The various features of the device 10 may be formed by ion implantation through the major surface 32 and heating of the substrate to diffuse the implanted ions. For instance, a device 10 of the kind shown in Figure 2 may be made by providing a semiconductor substrate including an epitaxial layer and by performing ion implantation for forming the source region 2, drain region 6, p-type region 8 and the region 40.

Since the region 40 in this embodiment is an extension of the drain region 6 that extends beneath the gate 4, the drain region 6 and the region 40 may be formed using the same implant. The implantation of ions for forming the drain region 6 and the region 40 (and also other features of the device 10) may be performed after the gate 4 has been formed. Because of this, the parts of the gate 4 that are already in place when the implantation of ions for the drain region 6 and region 40 is performed may cause shadowing of the region beneath the gate 4. This may lead to a pinching of the part of the drain region 6 located beneath the gate 4. Because of this pinching effect, a part 22 of the drain region 6 located beneath the gate 4 may extend to a depth beneath the major surface 32 that is shallower than a depth to which other parts of the drain region 6 extend. As shown in Figure 2, this part 22 may be peak shaped.

As explained below, it has been determined that the pinching of the drain region 6 beneath the gate 4 may improve the field distribution within the device, allowing for a higher maximum drain to source voltage BV_{dss} owing to an improved reduced surface field (RESURF) action in the device.

With reference to Figure 1, the process settings for an RF-LDMOS device of this kind (e.g. doping levels, junctions depths) are optimized for the RESURF effect within the device. In the device of Figure 1, a lateral depletion region formed at the interface between the drain region 106 and the epitaxial layer 120 beneath the gate 104 is an important part of this RESURF action. Returning to Figure 2, because the drain region 6 extends beneath the gate, the source region 2 and the region 8 having the second conductivity type, a depletion region beneath the gate 4, of the kind mentioned above in respect of Figure 1, may not be present. This may disturb the RESURF effect within the device 10. The part 22 of the drain region 6 located beneath the gate 4, which can give rise to a locally less deep junction between the drain region 6 (which has the first conductivity type) and the underlying epitaxial layer 20. This can cause the width of the depletion layer at the junction to be increased, which may allow the RESURF action in the device to be retained, notwithstanding the fact that the drain region 6 extends beneath the gate, the source region 2 and the region 8 having the second conductivity type.

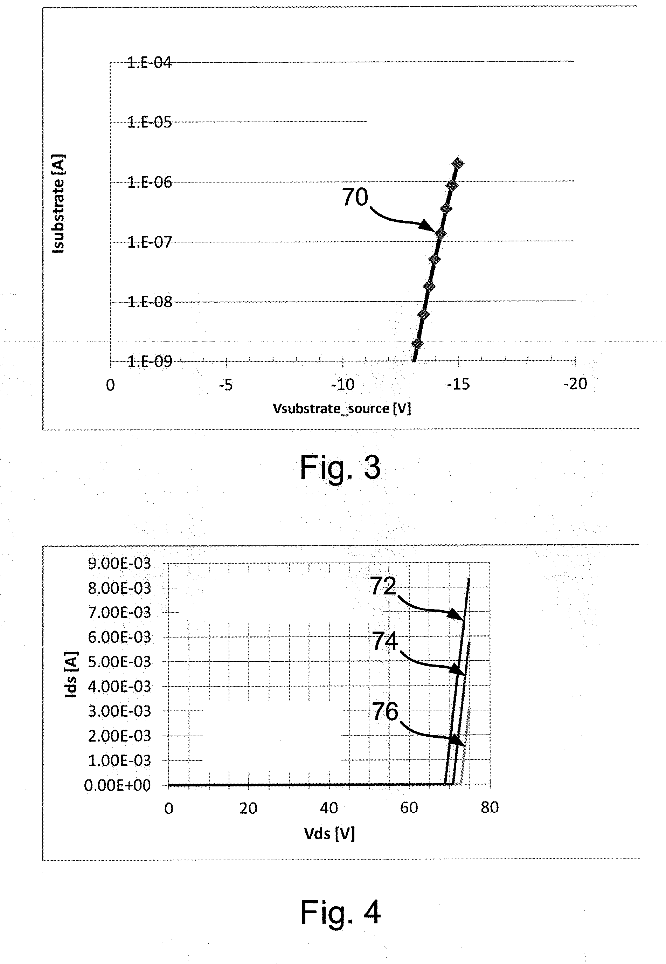

Figure 3 is a graph showing the source to substrate breakdown of a semiconductor device according to an embodiment of the present disclosure. These measurements were made with V_{gs} = 0V and V_{ds} = 27V. It is believed that further optimisation of the device may make breakdown voltages up to the supply voltage (28V) possible.

Figure 4 is a graph showing the drain to source breakdown of a semiconductor device according to an embodiment of the present disclosure. These measurements were made with V_{gs} = 0V and Vₛ = 0V. For plot 72, the substrate voltage was -5V. For plot 74, the substrate voltage was -2.5V. For plot 76, the substrate voltage was 0V.

Because the device 10 in Figure 2 may be operated as a source-high LDMOS transistor, it is used to implement the DC bias circuit in the RF power amplifier that includes an RF-LDMOS transistor. The device 10 is included in the same semiconductor substrate as the RF-LDMOS transistor for which the biasing is provided, thereby to provide compensation for temperature effects.

Although the device of Figure 2 is used in DC mode, in the biasing circuit as noted above, it is useful for understanding the invention, but not claimed that a device according to embodiments of the present disclosure may itself be used as an RF-LDMOS transistor.

A semiconductor device according to the invention is a power amplifier in RF applications. For instance, the power amplifier may be included in a base station of a communication system (e.g. GSM, EDGE, W-CDMA).

Accordingly, there has been described a power amplifier as claimed.

Although particular embodiments of the disclosure have been described, it will be appreciated that the scope of the present invention is defined in the claims.

## Claims

1. A power amplifier comprising a circuit that comprises an RF-LDMOS transistor and a DC biasing circuit for biasing the RF-LDMOS transistor, wherein the biasing circuit is incorporated into a same semiconductor substrate (11) as the RF-LDMOS transistor for which the bias point is to be provided, said semiconductor substrate (11) having a major surface (32), and wherein a source of the RF-LDMOS transistor is electrically connected to the semiconductor substrate (11);
wherein the DC biasing circuit includes a DC LDMOS transistor (10) that comprises:
a gate (4) located on the major surface (32);
a drain region (6) having a first conductivity type;
a source region (2) having the first conductivity type, wherein the source region (2) is located within a region (8) having a second conductivity type, said region (8) having the second conductivity extending laterally within the DC LDMOS transistor (10) to a greater extent than the source region (2) so as to surround the source region (2) beneath the major surface (32);
a channel region comprised of a part of said region (8) having the second conductivity type that is located beneath the gate (4); and
a common contact (30) connected to both the source region (2) and the region (8) having the second conductivity type;
wherein the semiconductor substrate (11) is doped to have the same conductivity type as the channel region, wherein the drain region (6) extends laterally away from the gate along the major surface (32) of the substrate (11) and wherein the drain region (6) also extends beneath the gate (4), the source region (2) and the region (8) having the second conductivity type, the drain region (6) surrounding the region (8) having the second conductivity type beneath the major surface (32) so that the source region (2) and the region (8) having the second conductivity type are electrically cut off from the underlying substrate (11).

2. The power amplifier of claim 1, wherein a part of the drain region (6) located beneath the gate (4) extends to a depth beneath the major surface (32) that is shallower than a depth to which a part of the drain region (6) not located beneath the gate (4) extends.

3. The power amplifier of any of the previous claims, wherein the common contact (30) comprises a silicide region located at the major surface (32), wherein the silicide region extends over a junction between the source region (2) and the region (8) having the second conductivity type.

4. The power amplifier of any of the previous claims, wherein the source region (2), the drain region (6), and the region (8) having the second conductivity type comprise doped regions located in an epitaxial layer of semiconductor material.

5. The power amplifier of any of the previous claims, wherein the first conductivity type is n-type and wherein the second conductivity type is p-type.

6. A base station comprising the power amplifier of any of the previous claims.

## Patentansprüche

1. Ein Leistungsverstärker mit einer Schaltung, die einen RF-LDMOS-Transistor und eine Gleichstrom-Vorspannungsschaltung zum Vorspannen des RF-LDMOS-Transistors aufweist, wobei die Vorspannungsschaltung in dasselbe Halbleitersubstrat (11) wie der RF-LDMOS-Transistor, für den der Vorspannungspunkt vorgesehen werden soll, eingebaut ist, wobei das Halbleitersubstrat (11) eine Hauptoberfläche (32) aufweist, und wobei eine Source des RF-DMOS-Transistors elektrisch mit dem Halbleitersubstrat (11) verbunden ist;
wobei die Gleichstrom-Vorspannungsschaltung einen Gleichstrom-LDMOS-Transistor (10) enthält, der Folgendes aufweist:
ein Gate (4), das sich auf der Hauptfläche (32) befindet;
einen Drain-Bereich (6) mit einem ersten Leitfähigkeitstyp;
einen Source-Bereich (2) mit dem ersten Leitfähigkeitstyp, wobei sich der Source-Bereich (2) innerhalb eines Bereichs (8) mit einem zweiten Leitfähigkeitstyp befindet, wobei sich der Bereich (8) mit der zweiten Leitfähigkeit seitlich innerhalb des DC-LDMOS-Transistors (10) in einem größeren Ausmaß als der Source-Bereich (2) erstreckt, so dass er den Source-Bereich (2) unterhalb der Hauptfläche (32) umgibt;
einen Kanalbereich, der aus einem Teil des Bereichs (8) mit dem zweiten Leitfähigkeitstyp besteht, der sich unter dem Gate (4) befindet; und
einen gemeinsamen Kontakt (30), der sowohl mit dem Source-Bereich (2) als auch mit dem Bereich (8) des zweiten Leitfähigkeitstyps verbunden ist;
wobei das Halbleitersubstrat (11) so dotiert ist, dass es den gleichen Leitfähigkeitstyp wie der Kanalbereich aufweist, wobei sich der Drainbereich (6) seitlich weg vom Gate entlang der Hauptoberfläche (32) des Substrats (11) erstreckt und wobei sich der Drainbereich (6) auch unter dem Gate (4) erstreckt, der Source-Bereich (2) und der Bereich (8) den zweiten Leitfähigkeitstyp aufweisen, wobei der Drain-Bereich (6) den Bereich (8) mit dem zweiten Leitfähigkeitstyp unterhalb der Hauptoberfläche (32) umgibt, so dass der Source-Bereich (2) und der Bereich (8) mit dem zweiten Leitfähigkeitstyp von dem darunter liegenden Substrat (11) elektrisch abgeschnitten sind.

2. Der Leistungsverstärker nach Anspruch 1, wobei sich ein Teil des Drain-Bereichs (6), der sich unterhalb des Gates (4) befindet, bis zu einer Tiefe unterhalb der Hauptoberfläche (32) erstreckt, die geringer ist als eine Tiefe, bis zu der sich ein Teil des Drain-Bereichs (6), der sich nicht unterhalb des Gates (4) befindet, erstreckt.

3. Der Leistungsverstärker nach einem der vorherigen Ansprüche, wobei der gemeinsame Kontakt (30) einen Silizidbereich umfasst, der sich an der Hauptfläche (32) befindet, wobei sich der Silizidbereich über einen Übergang zwischen dem Source-Bereich (2) und dem Bereich (8) mit dem zweiten Leitfähigkeitstyp erstreckt.

4. Der Leistungsverstärker nach einem der vorherigen Ansprüche, wobei der Source-Bereich (2), der Drain-Bereich (6) und der Bereich (8) mit dem zweiten Leitfähigkeitstyp dotierte Bereiche umfassen, die sich in einer Epitaxialschicht aus Halbleitermaterial befinden.

5. Der Leistungsverstärker nach einem der vorherigen Ansprüche, wobei der erste Leitfähigkeitstyp vom n-Typ ist und der zweite Leitfähigkeitstyp vom p-Typ ist.

6. Eine Basisstation mit dem Leistungsverstärker nach einem der vorherigen Ansprüche.

## Revendications

1. Amplificateur de puissance comprenant un circuit qui comprend un transistor LDMOS RF et un circuit de polarisation CC destiné à polariser le transistor LDMOS RF, dans lequel le circuit de polarisation est incorporé dans un même substrat semi-conducteur (11) que le transistor LDMOS RF pour lequel le point de polarisation doit être assuré, ledit substrat semi-conducteur (11) présentant une surface principale (32), et dans lequel une source du transistor LDMOS RF est raccordée électriquement au substrat semi-conducteur (11) ;
dans lequel le circuit de polarisation CC comprend un transistor LDMOS CC (10) qui comprend :
une grille (4) localisée sur la surface principale (32) ;
une zone de drain (6) présentant un premier type de conductivité ;
une zone de source (2) présentant le premier type de conductivité, dans lequel la zone de source (2) est située à l'intérieur d'une zone (8) présentant un second type de conductivité, ladite zone (8) présentant la seconde conductivité s'étendant latéralement à l'intérieur du transistor LDMOS CC (10) sur une étendue supérieure à celle de la zone de source (2) afin d'entourer la zone de source (2) au-dessous de la surface principale (32) ;
une zone de canal constituée par une partie de ladite zone (8) présentant le second type de conductivité qui est située au-dessous de la grille (4) ; et
un contact commun (30) raccordé à la fois à la zone de source (2) et à la zone (8) présentant le second type de conductivité ;
dans lequel le substrat semi-conducteur (11) est dopé de manière à présenter le même type de conductivité que la zone de canal, dans lequel la zone de drain (6) s'étend latéralement à l'opposé de la grille le long de la surface principale (32) du substrat (11) et dans lequel la zone de drain (6) s'étend aussi au-dessous de la grille (4), la zone de source (2) et la zone (8) présentant le second type de conductivité, la zone de drain (6) entourant la zone (8) présentant le second type de conductivité au-dessous de la surface principale (32) de telle sorte que la zone de source (2) et la zone (8) présentant le second type de conductivité sont électriquement découplées par rapport au substrat sous-jacent (11).

2. Amplificateur de puissance selon la revendication 1, dans lequel une partie de la zone de drain (6) située au-dessus de la grille (4) s'étend à une profondeur au-dessous de la surface principale (32) qui est inférieure à une profondeur à laquelle s'étend une partie de la zone de drain (6) non située au-dessous de la grille (4).

3. Amplificateur de puissance selon l'une quelconque des revendications précédentes, dans lequel le contact commun (30) comprend une zone de siliciure située au niveau de la surface principale (32), dans lequel la zone de siliciure s'étend au-dessus d'une jonction entre la zone de source (2) et la zone (8) présentant le second type de conductivité.

4. Amplificateur de puissance selon l'une quelconque des revendications précédentes, dans lequel la zone de source (2), la zone de drain (6) et la zone (8) présentant le second type de conductivité comprennent des zones dopées situées dans une couche épitaxiale de matériau semi-conducteur.

5. Amplificateur de puissance selon l'une quelconque des revendications précédentes, dans lequel le premier type de conductivité est le type n et dans lequel le second type de conductivité est le type p.

6. Station de base comprenant l'amplificateur de puissance selon l'une quelconque des revendications précédentes.
